# EUROPEAN PATENT APPLICATION

(11) **EP 4 518 609 A1**
(43) Date of publication of application: **05.03.2025**
(21) Application number: 24804722.7
(22) Date of filing: 21.06.2024
(51) Int. Cl.: H10B 12/00

(54) **SEMICONDUCTOR STRUCTURE AND MANUFACTURING METHOD THEREFOR**

(30) Priority: 12.07.2023 CN 202310850465
(71) Applicant: CXMT Corporation, Hefei City, Anhui Province 230601 (CN)
(72) Inventor: YU, Yexiao, Hefei, Anhui 230601 (CN); MA, Hong, Hefei, Anhui 230601 (CN); LIU, Zhongming, Hefei, Anhui 230601 (CN)
(74) Representative: Gulde & Partner
(86) International application number: PCT/CN2024/100565
(87) International publication number: WO 2025/011300

(57) **Abstract**

The semiconductor structure includes a substrate and a first bit line pillar. The first bit line pillar is located on the substrate, and includes a first dielectric layer, a first insulating layer, and a first contact layer that are successively stacked in a thickness direction of the substrate. The first insulating layer is adj acent to the substrate and has a first preset thickness. The first preset thickness is associated with a thickness sum of the first dielectric layer, the first insulating layer, and the first contact layer. A ratio of a length of a top surface of the first insulating layer in a first direction to a length of a bottom surface of the first insulating layer in the first direction is a first target value. The first direction, the top surface and the bottom surface of the first insulating layer are all perpendicular to the thickness direction.

## Description

This application claims priority to Chinese Patent Application No. 2023108504655, filed with the China National Intellectual Property Administration on July 12, 2023 and entitled "SEMICONDUCTOR STRUCTURE AND METHOD FOR FABRICATING SAME", which is incorporated herein by reference in its entirety.

### TECHNICAL FIELD

The present disclosure relates to the field of semiconductor technologies, and in particular, to a semiconductor structure and a method for fabricating same.

### BACKGROUND

A dynamic random access memory (DRAM) has advantages such as a high integration level, low power consumption, and a low price. Therefore, the DRAM is generally employed in a mass memory.

However, with high integration of semiconductors and evolution of Moore's Law to a level between 10 nm and 20 nm, it is required that arrangement of active regions be denser and a size of a memory cell be smaller. In particular, in a process of manufacturing a DRAM whose key size is less than 15 nm, it becomes more difficult to reduce a parasitic capacitance between bit lines. Therefore, a semiconductor structure and a method for fabricating same are urgently needed to reduce a parasitic capacitance while shrinking a semiconductor size, so as to improve performance of a storage device.

### SUMMARY

On this basis, the present disclosure provides a semiconductor structure and a method for fabricating same, so as to reduce a parasitic capacitance between bit lines, thereby improving overall performance of a semiconductor device.

According to embodiments of the present disclosure, an aspect provides a semiconductor structure including a substrate and a first bit line pillar. The first bit line pillar is located on the substrate, and includes a first dielectric layer, a first insulating layer, and a first contact layer that are successively stacked in a thickness direction of the substrate. The first insulating layer is adjacent to the substrate and has a first preset thickness. The first preset thickness is associated with a thickness sum of the first dielectric layer, the first insulating layer, and the first contact layer. A ratio of a length of a top surface of the first insulating layer in a first direction to a length of a bottom surface of the first insulating layer in the first direction is a first target value. The first direction, the top surface and the bottom surface of the first insulating layer all are perpendicular to the thickness direction.

In the semiconductor structure in the foregoing embodiments, the first insulating layer in the first bit line pillar has the first preset thickness, and the first preset thickness is related to the thickness sum of the first dielectric layer, the first insulating layer, and the first contact layer. To be specific, when the thickness sum of the first dielectric layer, the first insulating layer, and the first contact layer is unchanged, the first preset thickness can be reduced by increasing the thicknesses of the first dielectric layer and the first contact layer. In a related technology, due to complexity of multi-layer structure stacking and limitation of etching process precision, when a first bit line pillar is formed through etching, a portion of a layer structure of the first bit line pillar closer to the substrate is less completely etched on its sidewall. As a result, a sidewall of the first insulating layer cannot be completely perpendicular to the first direction, that is, a horizontal direction. In addition, because the portion close to the substrate is etched incompletely, the length of the bottom surface of the first insulating layer in the first direction is far greater than the length of the top surface of the first insulating layer in the first direction. Consequently, sizes of the bottom surface of the first insulating layer and a position close to the bottom surface in the first direction are large, occupying space in a sidewall direction of the first bit line pillar. As a result, a portion, close to the substrate, of a distance between the first bit line pillar and an adjacent bit line pillar is small, thereby increasing a parasitic capacitance and affecting overall performance of a device. According to the present disclosure, verticality of the sidewall of the first insulating layer is controlled by controlling the thickness of the first insulating layer, that is, the first preset thickness. When a proportion of the first preset thickness in the thickness sum of the first dielectric layer, the first insulating layer, and the first contact layer is smaller, the sidewall of the first insulating layer is more prone to be perpendicular to the first direction, and a difference between the length of the top surface of the first insulating layer in the first direction and the length of the bottom surface of the first insulating layer in the first direction is smaller. A length ratio is controlled to be the first target value, and verticality and performance of the first bit line pillar are better. In addition, better verticality of the first insulating layer can also leave more space in a sidewall direction of the first insulating layer, so that a spacing between the first bit line pillar and a bit line pillar adjacent to the first bit line pillar increases, thereby reducing a parasitic capacitance, and further improving overall performance of a storage structure.

In some embodiments, the first preset thickness is negatively correlated with both a thickness of the first dielectric layer and a thickness of the first contact layer; and a range of the first preset thickness is [1/6 T, 1/4 T], where T is the thickness sum of the first dielectric layer, the first insulating layer, and the first contact layer.

In some embodiments, the range of the first preset thickness is [3 nm, 10 nm].

In some embodiments, a range of the first target value is [0.8, 1].

In some embodiments, the semiconductor structure further includes a first bit line side barrier, which is located on an outer sidewall of the first bit line pillar, and a length of the first bit line side barrier in the first direction is associated with the length of the bottom surface of the first insulating layer in the first direction.

In some embodiments, the length of the first bit line side barrier in the first direction is negatively correlated with the length of the bottom surface of the first insulating layer in the first direction.

In some embodiments, the substrate includes an active region and an isolation structure that are alternately arranged in the first direction, the substrate includes a groove and a convex part that are alternately arranged in the first direction, and the first bit line pillar is located on a top surface of the convex part and is connected to the isolation structure under the first bit line pillar; and the semiconductor structure further includes a second bit line pillar, which is partially located within the groove, and is connected to an active region exposed by the groove.

In some embodiments, the first bit line pillar further includes a first barrier layer, a first conductive layer, and a first bit line cap layer that are successively stacked in the thickness direction of the substrate, the first contact layer is adjacent to the first barrier layer, and a thickness range of the first bit line cap layer is [10 nm, 30 nm].

In some embodiments, the second bit line pillar includes a bit line plug, a second barrier layer, a second conductive layer, and a second bit line cap layer that are successively stacked in the thickness direction, the bit line plug is connected to the active region exposed by the groove, and a thickness range of the second bit line cap layer is [10 nm, 30 nm].

Another aspect of the present disclosure further provides a method for fabricating a semiconductor structure. The method includes the steps as follows. A substrate is provided. A first bit line pillar is formed on the substrate. The first bit line pillar includes a first dielectric layer, a first insulating layer, and a first contact layer that are successively stacked in a thickness direction of the substrate. The first insulating layer is adjacent to the substrate and has a first preset thickness. The first preset thickness is associated with a thickness sum of the first dielectric layer, the first insulating layer, and the first contact layer. A ratio of a length of a top surface of the first insulating layer in a first direction to a length of a bottom surface of the first insulating layer in the first direction has a first target value. The first direction, the top surface and the bottom surface of the first insulating layer all are perpendicular to the thickness direction.

In the method for fabricating a semiconductor structure in the foregoing embodiments, the first dielectric layer, the first insulating layer, and the first contact layer that are successively stacked are formed in the thickness direction of the substrate; the first preset thickness is set to be associated with the thickness sum of the first dielectric layer, the first insulating layer, and the first contact layer; and the ratio of the length of the top surface of the first insulating layer in the first direction to the length of the bottom surface of the first insulating layer in the first direction has the first target value, so that an included angle between a sidewall of the first insulating layer and a surface of the substrate can be closer to 90°, and space between the first bit line pillar and the adjacent bit line pillar can be increased, so as to reduce a parasitic capacitance. The present disclosure overcomes a problem in the related technology that the sidewall of the first insulating layer cannot be completely perpendicular to the first direction, and the portion, close to the substrate, of the distance between the first bit line pillar and the adjacent bit line pillar is small. Verticality of the sidewall of the first insulating layer is controlled by controlling the thickness of the first insulating layer, that is, the first preset thickness. When a proportion of the first preset thickness in the thickness sum of the first dielectric layer, the first insulating layer, and the first contact layer is smaller, the sidewall of the first insulating layer is more prone to be perpendicular to the first direction, and the ratio of the length of the top surface of the first insulating layer in the first direction to the length of the bottom surface of the first insulating layer in the first direction is controlled to be the first target value, so that verticality and performance of the first bit line pillar are better. In addition, a spacing between the first bit line pillar and a bit line pillar adjacent to the first bit line pillar increases, and a parasitic capacitance is further reduced, thereby improving performance of a device.

In some embodiments, the substrate includes an active region and an isolation structure that are alternately arranged in the first direction, and the substrate includes a groove and a convex part that are alternately arranged in the first direction; the first dielectric layer is located on the convex part, and the first bit line pillar is located on a top surface of the convex part and is connected to the isolation structure under the first bit line pillar; and forming the first bit line pillar includes the steps as follows. An insulating material layer, a plug material layer, a barrier material layer, a conductive material layer, and a cap material layer that are stacked in the thickness direction are successively formed on the substrate. The insulating material layer is located on the first dielectric layer on the convex part, and the plug material layer at least fills a groove. The conductive material layer and the cap material layer are etched to form a first conductive layer and a first bit line cap layer that are successively stacked in the thickness direction. The insulating material layer, the plug material layer, and the barrier material layer are etched to form the first bit line pillar. The first bit line pillar includes the first dielectric layer, the first insulating layer, the first contact layer, a first barrier layer, the first conductive layer, and the first bit line cap layer that are successively stacked in the thickness direction.

In some embodiments, forming the first insulating layer, the first contact layer, and the first barrier layer includes the steps as follows. The insulating material layer, the plug material layer, and the barrier material layer are etched in a first preset process environment. The remaining insulating material layer forms the first insulating layer, a portion of the remaining plug material layer on the top surface of the first insulating layer forms the first contact layer, portions of the remaining plug material layer within the groove and on a top surface of the groove form an intermediate plug layer, a portion of the remaining barrier material layer on a top surface of the first contact layer forms the first barrier layer, and a portion of the remaining barrier material layer on a top surface of the intermediate plug layer forms a second barrier layer.

In some embodiments, the first preset process environment includes a first process gas and a first preset pressure; the first process gas is selected from chlorine, nitrogen trifluoride, nitrogen, an inert gas, and a combination thereof; and a range of the first preset pressure is [4 mt, 6 mt].

In some embodiments, forming the first conductive layer and the first bit line cap layer includes the steps as follows. The cap material layer is etched in a second preset process environment, and the conductive material layer is etched in a third preset process environment. A portion of the remaining conductive material layer on a top surface of the first barrier layer forms the first conductive layer, a portion of the remaining conductive material layer on a top surface of the second barrier layer forms a second conductive layer, a portion of the remaining cap material layer on a top surface of the first conductive layer forms the first bit line cap layer, and a portion of the remaining cap material layer on a top surface of the second conductive layer forms a second bit line cap layer.

In some embodiments, after forming the first bit line pillar, the method further includes the step as follows. The intermediate plug layer is processed in a fourth preset process environment to form bit line plugs that are arranged at intervals in the first direction, so as to form a second bit line pillar. The second bit line pillar includes the bit line plug, the second barrier layer, the second conductive layer, and the second bit line cap layer that are successively stacked in the thickness direction.

In some embodiments, the second preset process environment includes a second process gas and a second preset pressure; the second process gas is selected from carbon tetrafluoride, trifluoromethane, oxygen, nitrogen, an inert gas, and a combination thereof; and a range of the second preset pressure is [13 mt, 17 mt].

In some embodiments, the third preset process environment includes a third process gas and a third preset pressure; the third process gas is selected from chlorine, nitrogen trifluoride, oxygen, nitrogen, an inert gas, and a combination thereof; and a range of the third preset pressure is [4 mt, 6 mt].

In some embodiments, the fourth preset process environment includes a fourth process gas and a fourth preset pressure; the fourth process gas is selected from hydrogen bromide, oxygen, an inert gas, and a combination thereof; and a range of the fourth preset pressure is [18 mt, 22 mt].

### BRIEF DESCRIPTION OF DRAWINGS

To describe the technical solutions in the embodiments of the present disclosure more clearly, the following briefly describes the accompanying drawings required for describing the embodiments. Clearly, the accompanying drawings in the following description show merely some embodiments of the present disclosure, and a person of ordinary skill in the art may still derive other drawings from these accompanying drawings without creative efforts.
FIG. 1 is a schematic cross-sectional view of a semiconductor structure according to an embodiment of the present disclosure;
FIG. 2 is a schematic cross-sectional view of a semiconductor structure in a related technology according to an embodiment of the present disclosure;
FIG. 3 is a schematic cross-sectional view of a semiconductor structure according to another embodiment of the present disclosure;
FIG. 4 is a schematic diagram of a curve of a relationship between a first preset thickness and a contact area between a capacitive plug and an active region according to an embodiment of the present disclosure;
FIG. 5 is a schematic flowchart of a method for fabricating a semiconductor structure according to an embodiment of the present disclosure;
FIG. 6 is a schematic diagram of a cross-sectional structure for forming an initial isolation material layer in a substrate according to an embodiment of the present disclosure;
FIG. 7 is a schematic diagram of a cross-sectional structure for forming an intermediate isolation material layer on the structure shown in FIG. 6 according to an embodiment of the present disclosure;
FIG. 8 is a schematic diagram of a cross-sectional structure for forming an isolation structure, a first dielectric layer, an insulating material layer, and a plug material layer on the structure shown in FIG. 7 according to an embodiment of the present disclosure;
FIG. 9 is a schematic diagram of a cross-sectional structure for forming a barrier material layer, a conductive material layer, and a cap material layer on the structure shown in FIG. 8 according to an embodiment of the present disclosure;
FIG. 10 is a schematic diagram of a cross-sectional structure for forming a first mask layer and a second mask layer on the structure shown in FIG. 9 according to an embodiment of the present disclosure;
FIG. 11 is a schematic diagram of a cross-sectional structure for forming a first bit line cap layer and a second bit line cap layer on the structure shown in FIG. 10 according to an embodiment of the present disclosure;
FIG. 12 is a schematic diagram of a cross-sectional structure for forming a first conductive layer and a second conductive layer on the structure shown in FIG. 11 according to an embodiment of the present disclosure;
FIG. 13 is a schematic diagram of a cross-sectional structure for forming a first insulating layer, a first contact layer, a first barrier layer, a second barrier layer, and an intermediate plug layer on the structure shown in FIG. 12 according to an embodiment of the present disclosure;
FIG. 14 is a schematic diagram of a cross-sectional structure for forming a bit line plug on the structure shown in FIG. 13 according to an embodiment of the present disclosure;
FIG. 15 is a schematic diagram of a cross-sectional structure for forming a first dielectric layer and a fourth dielectric layer on the structure shown in FIG. 14 according to an embodiment of the present disclosure;
FIG. 16 is a schematic diagram of a cross-sectional structure for forming a second dielectric layer and a fifth dielectric layer on the structure shown in FIG. 15 according to an embodiment of the present disclosure;
FIG. 17 is a schematic diagram of a cross-sectional structure for forming a third dielectric layer, a sixth dielectric layer, and a first isolation layer on the structure shown in FIG. 16 according to an embodiment of the present disclosure;
FIG. 18 is a schematic diagram of a cross-sectional structure for forming a second isolation layer and a third isolation layer on the structure shown in FIG. 17 according to an embodiment of the present disclosure;
FIG. 19 is a schematic diagram of a cross-sectional structure for forming a third dielectric layer and a sixth dielectric layer on the structure shown in FIG. 15 according to an embodiment of the present disclosure; and
FIG. 20 is a schematic diagram of a cross-sectional structure for forming a capacitive plug trench on the structure shown in FIG. 19 according to an embodiment of the present disclosure.

Descriptions of reference numerals:
10. substrate; 101. active region; 102. isolation structure; 1021. initial isolation material layer; 1022. intermediate isolation material layer; 10a. groove; 10b. convex part; 111. insulating material layer; 112. plug material layer; 113. barrier material layer; 114. conductive material layer; 115. cap material layer; 121. first mask layer; 122. second mask layer; 13. first bit line pillar; 131. first dielectric layer; 132. first insulating layer; 133. first contact layer; 134. first barrier layer; 135. first conductive layer; 136. first bit line cap layer; 14. second bit line pillar; 141. bit line plug; 1411. intermediate plug layer; 142. second barrier layer; 143. second conductive layer; 144. second bit line cap layer; 15. first bit line side barrier; 151. first dielectric layer; 152. second dielectric layer; 153. third dielectric layer; 16. second bit line side barrier; 161. fourth dielectric layer; 162. fifth dielectric layer; 1621. fifth sub-dielectric layer; 163. sixth dielectric layer; 1631. sixth sub-dielectric layer; 17. first isolation layer; 18. second isolation layer; 19. third isolation layer; 20. capacitive plug trench; 21. capacitive plug; 30. active layer; 31. first bit line structure; 311. dielectric layer; 312. insulating layer; 313/321. contact layer; 314/322. barrier layer; 315/323. conductive layer; 316/324. cap layer; 32. second bit line structure; 33. bit line side barrier; 331. first sub-side barrier; 332. second sub-side barrier; 333. third sub-side barrier.

### DESCRIPTION OF EMBODIMENTS

For ease of understanding of the present disclosure, a more comprehensive description of the present disclosure is provided below with reference to related accompanying drawings. A preferred embodiment of the present disclosure is provided in the accompanying drawings. However, the present disclosure may be implemented in many different forms, and is not limited to the embodiments described in this specification. On the contrary, the purpose of providing these embodiments is to make the content of the present disclosure more thorough and comprehensive. Unless otherwise defined, all technical and scientific terms employed in this specification have the same meanings as those commonly understood by a person skilled in the technical field of the present disclosure. The terms employed in the specification of the present disclosure are merely intended to describe specific embodiments, and are not intended to limit the present disclosure.

It should be understood that, an element or a layer may be directly on, adjacent to, connected to, or coupled to another element or layer or there may be an intermediate element or layer when the element or the layer is referred to as "on", "adjacent to", "connected to", or "coupled to" the another element or layer. On the contrary, there is no intermediate element or layer when an element is referred to as "directly on", "directly adjacent to", "directly connected to", or "directly coupled to" another element or layer. Spatial relationship terms, e.g., "under", "below", "underlying", "beneath", "over", "above", and the like may be employed herein to describe a relationship between one element or feature shown in the figures and another element or feature.

It should be understood that in addition to the orientations shown in the figures, the spatial relationship terms further include different orientations of devices in application and operation. For example, an element or a feature described as "below another element", "thereunder", or "beneath" is oriented to be "above" the another element or feature if the devices in the accompanying drawings are flipped. Therefore, the example terms "below" and "beneath" may include orientations of being above and being below. In addition, the devices may alternatively include other orientations (e.g., rotation by 90 degrees or another orientation), and the spatial descriptors employed herein are interpreted accordingly. As employed herein, the singular forms of "a", "an", and "the" may also be intended to include plural forms unless otherwise clearly specified in the context. It should also be understood that, the presence of the feature, integer, step, operation, element, and/or component can be determined without ruling out the presence or addition of one or more other features, integers, steps, operations, elements, components, and/or groups when the term "constitute" and/or the term "include" are/is employed in the specification. Moreover, as employed herein, the term "and/or" includes any and all combinations of the related items listed.

It should be noted that, the illustrations provided in the embodiments merely describe the basic concept of the present disclosure by way of examples. Although the drawings show only components related to the present disclosure, and are not drawn based on a quantity of components, a shape of a component, and a size of a component during actual implementation, a shape, a quantity, and a scale of the components may be arbitrarily changed during actual implementation, and a component layout form may be more complex.

A memory is a memory component configured to store a program and various types of data information. The memory may be classified into a read-only memory (ROM) and a random access memory (RAM) based on an application type of the memory. The RAM is classified into a static RAM (SRAM) and a DRAM based on different working principles of a memory cell. Compared with the SRAM, the DRAM has advantages such as a high integration level, low power consumption, and a low price. Therefore, the DRAM is generally employed in a mass memory. A basic memory cell in the DRAM includes two elements: a transistor and a capacitor. The transistor is configured to charge or discharge the capacitor. Both charging and discharging are performed through a word line and a bit line.

With high integration of semiconductors and evolution of Moore's Law to a level of 1x nm, that is, between 10 nm and 20 nm, it is required that arrangement of active regions be denser. With development of a dynamic random access memory technology, a size of a memory cell is smaller, a process difficulty of a structure in the memory is higher, and there is a common problem of a large parasitic capacitance in a device. Based on the foregoing technical problems, the present disclosure provides a semiconductor structure and a method for fabricating same, so as to reduce a parasitic capacitance between bit lines, thereby improving overall performance of a semiconductor device.

It should be noted that in the present disclosure, a thickness direction of a substrate may be an oy direction, and a first direction may be an ox direction.

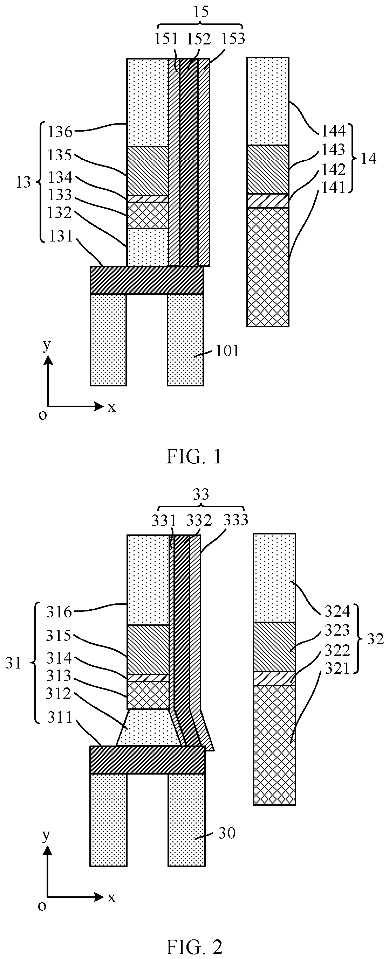

In an example, reference is made to FIG. 1. An aspect of the present disclosure provides a semiconductor structure including a substrate (not shown in the figure) and a first bit line pillar 13. The first bit line pillar 13 is located on the substrate, and includes a first dielectric layer 131, a first insulating layer 132, and a first contact layer 133 that are successively stacked in a thickness direction (e.g., the oy direction) of the substrate 10. The first insulating layer 132 is adjacent to the substrate 10 and has a first preset thickness. The first preset thickness is associated with a thickness sum of the first dielectric layer 131, the first insulating layer 132, and the first contact layer 133. A ratio of a length of a top surface of the first insulating layer 132 in a first direction (e.g., the ox direction) to a length of a bottom surface of the first insulating layer 132 in the first direction (e.g., the ox direction) is a first target value. The first direction (e.g., the ox direction), the top surface and the bottom surface of the first insulating layer 132 all are perpendicular to the thickness direction (e.g., the oy direction).

In the semiconductor structure in the foregoing embodiments, the first insulating layer 132 in the first bit line pillar 13 has the first preset thickness, and the first preset thickness is related to the thickness sum of the first dielectric layer 131, the first insulating layer 132, and the first contact layer 133. To be specific, when the thickness sum of the first dielectric layer 131, the first insulating layer 132, and the first contact layer 133 is unchanged, the first preset thickness can be reduced by increasing the thicknesses of the first dielectric layer 131 and the first contact layer 133. In a related technology, due to complexity of multi-layer structure stacking and limitation of etching process precision, when a first bit line pillar 13 is formed through etching, a portion of a layer structure of the first bit line pillar 13 closer to the substrate is less completely etched on its sidewall. As a result, a sidewall of the first insulating layer 132 cannot be completely perpendicular to the first direction (e.g., the ox direction), that is, a horizontal direction. In addition, because the portion close to the substrate is etched incompletely, the length of the bottom surface of the first insulating layer 132 in the first direction (e.g., the ox direction) is far greater than the length of the top surface of the first insulating layer 132 in the first direction (e.g., the ox direction). Consequently, sizes of the bottom surface of the first insulating layer 132 and a position close to the bottom surface in the first direction (e.g., the ox direction) are large, occupying space in a sidewall direction of the first bit line pillar 13. As a result, a portion, close to the substrate, of a distance between the first bit line pillar and an adjacent bit line pillar is small, thereby increasing a parasitic capacitance and affecting overall performance of a device. According to the present disclosure, verticality of the sidewall of the first insulating layer 132 is controlled by controlling the thickness of the first insulating layer 132, that is, the first preset thickness. When a proportion of the first preset thickness in the thickness sum of the first dielectric layer 131, the first insulating layer 132, and the first contact layer 133 is smaller, the sidewall of the first insulating layer 132 is more prone to be perpendicular to the first direction (e.g., the ox direction), and a difference between the length of the top surface of the first insulating layer 132 in the first direction (e.g., the ox direction) and the length of the bottom surface of the first insulating layer 132 in the first direction (e.g., the ox direction) is smaller. A length ratio is controlled to be the first target value, and verticality and performance of the first bit line pillar 13 are better. In addition, better verticality of the first insulating layer 132 can also leave more space in a sidewall direction of the first insulating layer 132, so that a spacing between the first bit line pillar 13 and a bit line pillar adjacent to the first bit line pillar 13 increases, thereby reducing a parasitic capacitance, and further improving overall performance of a storage structure.

In an example, reference is made to FIG. 1 and FIG. 2. FIG. 2 is a schematic cross-sectional view of an existing first bit line structure 31 and an existing second bit line structure 32 in a related technology. The first bit line structure 31 is connected to an isolation insulating region (not shown in the figure) in a substrate (not shown in the figure), and the second bit line structure 32 is connected to an active layer 30 in the substrate. The first bit line structure 31 includes a dielectric layer 311, an insulating layer 312, a contact layer 313, a barrier layer 314, a conductive layer 315, and a cap layer 316 that are successively stacked in a direction away from a surface of the substrate. The second bit line structure 32 includes a contact layer 321, a barrier layer 322, a conductive layer 323, and a cap layer 324 that are successively stacked in the direction away from the surface of the substrate. In the related technology, generally, due to complexity of multi-layer structure stacking and limitation of etching process precision, a sidewall of the insulating layer 312 cannot be completely perpendicular to the first direction (e.g., the ox direction), that is, a horizontal direction. In addition, because the portion close to the substrate is etched incompletely, a length range of the bottom surface of the insulating layer 312 in the first direction (e.g., the ox direction) is [21.8 nm, 22.0 nm]. Consequently, in the related technology, the insulating layer 312 is generally greater than or even far greater than a length range [9.0 nm, 9.2 nm] of the top surface of the insulating layer 312 in the first direction (e.g., the ox direction), occupying space in a sidewall direction of the first bit line structure 31. A range of a ratio of the length of the top surface of the insulating layer 312 in the first direction(e.g., the ox direction) to the length of the bottom surface of the insulating layer 312 in the first direction (e.g., the ox direction) is [0.4, 0.6]. As a result, a portion, close to the substrate, of a distance between the first bit line structure 31 and the adjacent second bit line structure 32 is small, thereby increasing a parasitic capacitance of a nearby region. However, in the semiconductor structure provided in the present disclosure, because the thickness of the first insulating layer 132 is controlled, verticality of the sidewall of the first insulating layer 132 to the first direction (e.g., the ox direction) is improved. In addition, because the portion close to the substrate is etched completely, a length range of the bottom surface of the first insulating layer 132 in the first direction (e.g., the ox direction) is [9.8 nm, 10.0 nm]. Specifically, the length of the bottom surface of the first insulating layer 132 in the first direction (e.g., the ox direction) may be 9.8 nm, 9.83 nm, 9.86 nm, 9.9 nm, 9.95 nm, 10.0 nm, or the like. A size is close to a length range [8.5 nm, 8.7 nm] of the top surface of the first insulating layer 132 in the first direction (e.g., the ox direction). Specifically, the length of the top surface of the first insulating layer 132 in the first direction (e.g., the ox direction) may be 8.5 nm, 8.53 nm, 8.6 nm, 8.63 nm, 8.66 nm, 8.7 nm, or the like, so that space between the first bit line pillar 13 and the second bit line pillar 14 is larger. In addition, the ratio of the length of the top surface of the first bit line pillar 13 in the first direction(e.g., the ox direction) to the length of the bottom surface of the first bit line pillar 13 in the first direction (e.g., the ox direction) has the first target value. A range of the first target value is [0.8, 1], so that verticality of the first bit line pillar 13 is better. Specifically, the first target value may be 0.8, 0.85, 0.9, 0.95, 1, or the like.

In an example, reference is still made to FIG. 1. The first preset thickness is negatively correlated with both a thickness of the first dielectric layer 131 and a thickness of the first contact layer 133. Specifically, in the present disclosure, the smaller first preset thickness indicates the larger thickness of the first contact layer and the larger thickness of the first dielectric layer. Therefore, a proportion of the first preset thickness in the thickness sum of the first dielectric layer 131, the first insulating layer 132, and the first contact layer 133 is smaller, so that verticality of the sidewall surface of the first dielectric layer 131, the first insulating layer 132, and the first contact layer 133 as a whole is better. A range of the first preset thickness is [1/6 T, 1/4 T], where T is the thickness sum of the first dielectric layer 131, the first insulating layer 132, and the first contact layer 133. Specifically, the first preset thickness may be 1/6 T, 1/5 T, 1/4 T, or the like. When the thickness sum of the first dielectric layer 131, the first insulating layer 132, and the first contact layer 133 is unchanged, the first preset thickness can be reduced by increasing the thicknesses of the first dielectric layer 131 and the first contact layer 133. In other words, the proportion of the first preset thickness in the foregoing thickness sum is reduced. Therefore, etching difficulty is lower, so that the first insulating layer 132 whose sidewall is better perpendicular to the first direction (e.g., the ox direction) can be obtained, thereby reducing a parasitic capacitance and improving a sensing margin.

In an example, reference is still made to FIG. 1. The semiconductor structure further includes a first bit line side barrier 15, which is located on an outer sidewall of the first bit line pillar 13, and a length of the first bit line side barrier 15 in the first direction (e.g., the ox direction) is associated with the length of the bottom surface of the first insulating layer 132 in the first direction (e.g., the ox direction). When the length of the bottom surface of the first insulating layer 132 in the first direction (e.g., the ox direction) is reduced, space can be provided for the first bit line side barrier 15 adjacent to the first insulating layer 132, so that a size of the first bit line side barrier 15 in the first direction (e.g., the ox direction) is increased.

In an example, reference is still made to FIG. 1. The length of the first bit line side barrier 15 in the first direction (e.g., the ox direction) is negatively correlated with the length of the bottom surface of the first insulating layer 132 in the first direction (e.g., the ox direction). Therefore, when the length of the bottom surface of the first insulating layer 132 in the first direction (e.g., the ox direction) is reduced, the first bit line side barrier 15 can be thickened, thereby better providing isolation between the first bit line pillar 13 and the second bit line pillar 14. In this way, a parasitic capacitance between the first bit line pillar 13 and the second bit line pillar 14 is reduced.

In an example, reference is still made to FIG. 1. The first bit line side barrier 15 includes a first dielectric layer 151, a second dielectric layer 152, and a third dielectric layer 153 that are successively arranged in a direction away from the first bit line pillar 13. A material of the first dielectric layer 151 is the same as a material of the third dielectric layer 153, and is different from a material of the second dielectric layer 152. The first bit line side barrier 15 is located in a gap between the first bit line pillar 13 and the second bit line pillar 14, and can isolate the first bit line pillar 13 from the second bit line pillar 14, so as to reduce a parasitic capacitance.

In an example, reference is still made to FIG. 1 and FIG. 2. When the length of the bottom surface of the first insulating layer 132 in the first direction (e.g., the ox direction) is reduced, space is provided for an increase in the length of the first bit line side barrier 15 in the first direction (e.g., the ox direction). Therefore, the first bit line side barrier 15 can be thickened with a decrease in a size of the bottom surface of the first insulating layer 132. Specifically, the lengths of the second dielectric layer 152 and the third dielectric layer 153 in the first direction (e.g., the ox direction) may be increased, so as to better provide isolation and reduce a parasitic capacitance.

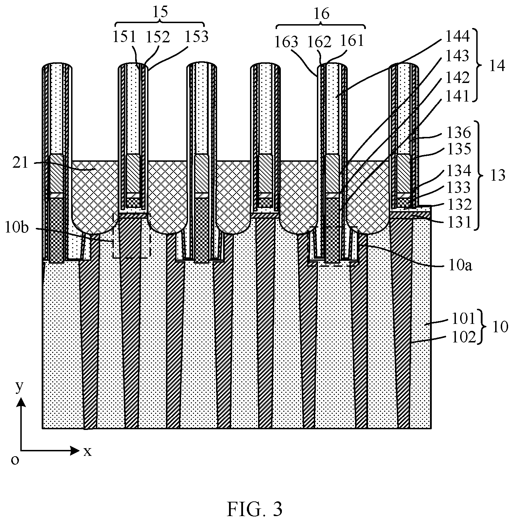

In an example, reference is made to FIG. 3. The substrate 10 includes an active region 101 and an isolation structure 102 that are alternately arranged in the first direction (e.g., the ox direction), and the substrate 10 includes a groove 10a and a convex part 10b that are alternately arranged in the first direction (e.g., the ox direction). The first bit line pillar 13 is located on a top surface of the convex part 10b and is connected to the isolation structure 102 under the first bit line pillar 13. The semiconductor structure further includes a second bit line pillar 14, which is partially located within the groove 10a, and is connected to an active region 101 exposed by the groove 10a. In other words, the second bit line pillar 14 is a bit line pillar employed by a memory during actual working, and the second bit line pillar 14 and the first bit line pillar 13 are arranged at intervals and adjacent to each other. In a case in which a semiconductor size is gradually miniaturized, a parasitic capacitance between the second bit line pillar 14 and the first bit line pillar 13 is increased. According to the present disclosure, a spacing between the second bit line pillar 14 and the first bit line pillar 13 can be increased by setting a size and a structure of the first insulating layer 132, so that a parasitic capacitance can be reduced and a problem of a sensing margin can be alleviated.

In an example, reference is made to FIG. 1 and FIG. 3. The first bit line pillar 13 further includes a first barrier layer 134, a first conductive layer 135, and a first bit line cap layer 136 that are successively stacked in the thickness direction (e.g., the oy direction) of the substrate 10, the first contact layer 133 is adjacent to the first barrier layer 134, and a thickness range of the first bit line cap layer 136 is [10 nm, 30 nm]. Specifically, the thickness of the first bit line cap layer 136 may be 10 nm, 15 nm, 20 nm, 25 nm, 30 nm, or the like. The first bit line cap layer 136 is set to be within the foregoing thickness range, so that a problem that the first bit line pillar 13 is prone to tilt or even collapse can be alleviated, and stability performance of the first bit line pillar 13 can be improved, thereby improving overall performance of the memory.

In an example, reference is still made to FIG. 1 and FIG. 3. The second bit line pillar 14 includes a bit line plug 141, a second barrier layer 142, a second conductive layer 143, and a second bit line cap layer 144 that are successively stacked in the thickness direction (e.g., the oy direction), the bit line plug 141 is connected to the active region 101 exposed by the groove 10a, and a thickness range of the second bit line cap layer 144 is [10 nm, 30 nm]. Specifically, the thickness of the second bit line cap layer 144 may be 10 nm, 15 nm, 20 nm, 25 nm, 30 nm, or the like. The thickness of the second bit line cap layer 144 may be the same as the thickness of the first bit line cap layer 136. The second bit line cap layer 144 is set to be within the foregoing thickness range, so that a problem that the second bit line pillar 14 is prone to tilt or even collapse can be alleviated, and stability performance of the second bit line pillar 14 can be improved.

In an example, reference is still made to FIG. 3. The semiconductor structure further includes a capacitive plug 21, which is located between the first bit line pillar 13 and the second bit line pillar 14 that are adjacent to each other in the first direction (e.g., the ox direction), and is connected to the active region 101 under the capacitive plug 21. The capacitive plug 21 is configured to connect the capacitor structure to the active region 101 to form a memory cell.

In an example, reference is still made to FIG. 3. The semiconductor structure further includes a capacitor contact layer (not shown in the figure), which is located on a side, away from the substrate 10, of the capacitive plug 21 in the thickness direction (e.g., the oy direction). A capacitor structure (not shown in the figure) is further disposed on a side, away from the substrate 10, of the capacitor contact layer in the thickness direction (e.g., the oy direction). The capacitor structure and the second bit line pillar 14 are configured to jointly form a memory cell.

In an example, reference is still made to FIG. 1. The range of the first preset thickness is [3 nm, 10 nm]. Specifically, the first preset thickness may be 3 nm, 4 nm, 5 nm, 8 nm, 10 nm, or the like.

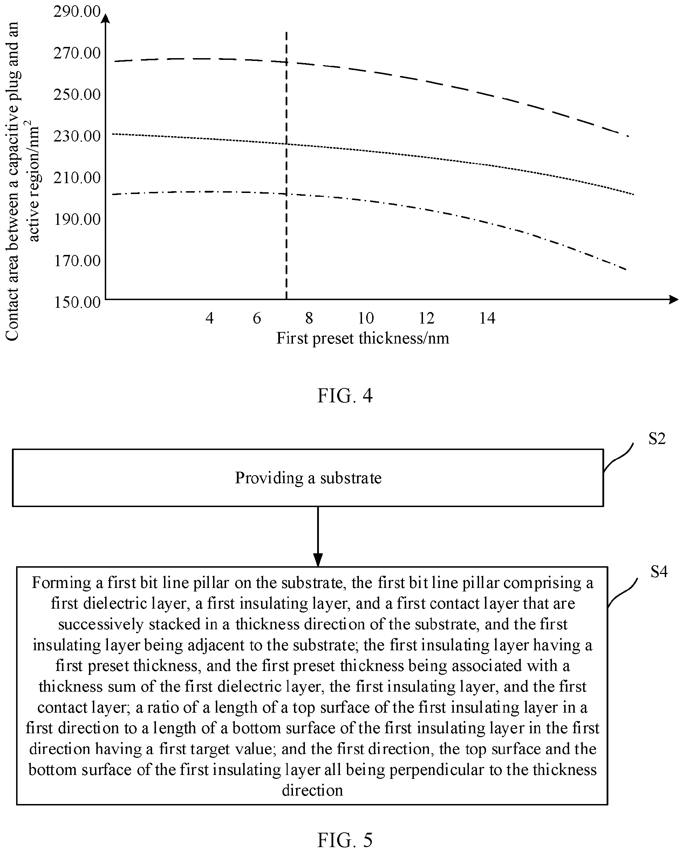

In an example, reference is made to FIG. 3 and FIG. 4. FIG. 4 shows impact of a change of the first preset thickness in the first bit line pillar 13 on a contact area between the capacitive plug 21 and the active region 101 in three cases in which the first insulating layer 132 has different topographies. Three curves respectively represent, from top to bottom, structures in which verticality of a sidewall, close to the bottom, of the bit line gradually deteriorates. To be specific, in the three curves, verticality of the sidewall of the first insulating layer successively deteriorates from top to bottom. As a result, space occupied by the first insulating layer successively increases from top to bottom, thereby occupying increasingly large space of the capacitive plug 21. Therefore, the structure represented by the lowermost curve occupies the largest space of the capacitive plug 21. Consequently, a contact area between the capacitive plug 21 and the active region 101 under the capacitive plug 21 is the smallest, and a contact effect is the worst. It can be further seen from FIG. 4 that, in the same curve, when the first preset thickness is greater than 8 nm, a decreasing trend of the contact area between the capacitive plug 21 and the active region 101 is increasingly fast, leading to an increasingly large difference from a preset contact area. Therefore, the first preset thickness is set to [3 nm, 10 nm], so that the contact area between the capacitive plug 21 and the active region 101 can be stabilized near a preset value, thereby improving conductive performance and contact performance of the semiconductor structure.

In an example, reference is made to FIG. 5. Another aspect of the present disclosure further provides a method for fabricating a semiconductor structure. The method includes the steps as follows.

In the step of S2, a substrate is provided.

In the step of S4, a first bit line pillar is formed on the substrate. The first bit line pillar includes a first dielectric layer, a first insulating layer, and a first contact layer that are successively stacked in a thickness direction of the substrate. The first insulating layer is adjacent to the substrate and has a first preset thickness. The first preset thickness is associated with a thickness sum of the first dielectric layer, the first insulating layer, and the first contact layer. A ratio of a length of a top surface of the first insulating layer in a first direction to a length of a bottom surface of the first insulating layer in the first direction has a first target value. The first direction, the top surface and the bottom surface of the first insulating layer all are perpendicular to the thickness direction.

In the method for fabricating a semiconductor structure in the foregoing embodiments, the first dielectric layer, the first insulating layer, and the first contact layer that are successively stacked are formed in the thickness direction of the substrate; the first preset thickness is set to be associated with the thickness sum of the first dielectric layer, the first insulating layer, and the first contact layer; and the ratio of the length of the top surface of the first insulating layer in the first direction to the length of the bottom surface of the first insulating layer in the first direction has the first target value, so that an included angle between a sidewall of the first insulating layer and a surface of the substrate can be closer to 90°, and space between the first bit line pillar and the adjacent bit line pillar can be increased, so as to reduce a parasitic capacitance. The present disclosure overcomes a problem in the related technology that the sidewall of the first insulating layer cannot be completely perpendicular to the first direction, and the portion, close to the substrate, of the distance between the first bit line pillar and the adjacent bit line pillar is small. Verticality of the sidewall of the first insulating layer is controlled by controlling the thickness of the first insulating layer, that is, the first preset thickness. When a proportion of the first preset thickness in the thickness sum of the first dielectric layer, the first insulating layer, and the first contact layer is smaller, the sidewall of the first insulating layer is more prone to be perpendicular to the first direction, and the ratio of the length of the top surface of the first insulating layer in the first direction to the length of the bottom surface of the first insulating layer in the first direction is controlled to be the first target value, so that verticality and performance of the first bit line pillar are better. In addition, a spacing between the first bit line pillar and a bit line pillar adjacent to the first bit line pillar increases, and a parasitic capacitance is further reduced, thereby improving performance of a device.

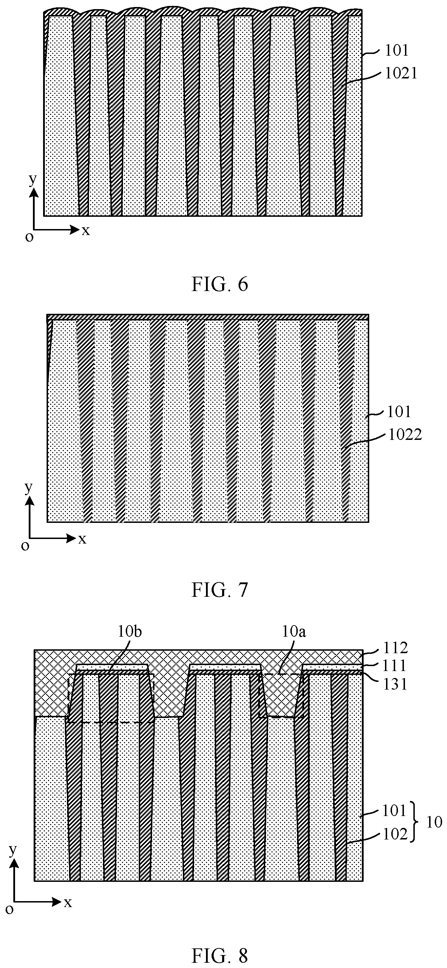

In an example, reference is made to FIG. 6 to FIG. 8. The step of S4 includes the step as follows.

In the step of S41, an active region 101 and an isolation structure 102 that are alternately arranged in the first direction (e.g., the ox direction) are formed in the substrate 10. The substrate 10 includes a groove 10a and a convex part 10b that are alternately arranged in the first direction (e.g., the ox direction). The first dielectric layer 131 is located on the convex part 10b, and the first bit line pillar 13 is located on a top surface of the convex part 10b and is connected to the isolation structure 102 under the first bit line pillar 13.

In an example, reference is made to FIG. 6. The step of S41 includes the step as follows.

In the step of S411, initial isolation material layers 1021 arranged at intervals in the first direction (e.g., the ox direction) are formed in the substrate 10. Each of the initial isolation material layers 1021 is configured to define a position of the active region 101.

In the step of S411, the initial isolation material layer 1021 further covers a top surface of the substrate 10, and a material of the initial isolation material layer 1021 may include one or more of silicon oxide or another insulating material.

In an example, reference is still made to FIG. 6. The substrate 10 may be made of a semiconductor material, an insulating material, a conductor material, or any combination thereof. The substrate 10 may be a single-layer structure, or may be a multi-layer structure. For example, the substrate 10 may be a silicon (Si) substrate, a silicon germanium (SiGe) substrate, a silicon germanium carbon (SiGeC) substrate, a silicon carbide (SiC) substrate, a gallium arsenide (GaAs) substrate, an indium arsenide (InAs) substrate, an indium phosphide (InP) substrate, or another III/V semiconductor substrate or II/VI semiconductor substrate. Alternatively, for another example, the substrate 10 may be a layered substrate including Si/SiGe, Si/SiC, silicon on insulator (SOI), or silicon germanium on insulator. A person skilled in the art may select a type of the substrate 10 based on a type of a transistor formed on the substrate 10. Therefore, the type of the substrate 10 should not limit the protection scope of the present disclosure.

In an example, reference is made to FIG. 7. The step of S41 further includes the step as follows.

In the step of S412, planarization processing is performed on a top surface of the initial isolation material layer 1021 to form an intermediate isolation material layer 1022.

In the step of S412, the planarization processing technique may be one or more of processes such as chemical mechanical polishing (CMP), etching-back, and physical polishing.

In an example, reference is made to FIG. 8. The step of S41 includes the step as follows.

In the step of S413, a groove 10a and a convex part 10b that are alternately arranged in the first direction (e.g., the ox direction) are formed on the surface of the substrate 10. A portion of the intermediate isolation material layer 1022 on the top surface of the convex part 10b is the first dielectric layer 131.

In the step of S413, the groove 10a exposes at least the top surface of the active region 101, and the first dielectric layer 131 is connected to at least the top surface of the isolation structure 102.

In an example, reference is made to FIG. 8 to FIG. 13. Forming the first bit line pillar 13 includes the steps as follows.

In the step of S42, an insulating material layer 111, a plug material layer 112, a barrier material layer 113, a conductive material layer 114, and a cap material layer 115 that are stacked in the thickness direction (e.g., the oy direction) are successively formed on the substrate 10. The insulating material layer 111 is located on the first dielectric layer 131 on the convex part 10b, and the plug material layer 112 at least fills the groove 10a.

In the step of S43, the conductive material layer 114 and the cap material layer 115 are etched to form a first conductive layer 135 and a first bit line cap layer 136 that are successively stacked in the thickness direction (e.g., the oy direction).

In the step of S44, the insulating material layer 111, the plug material layer 112, and the barrier material layer 113 are etched to form the first bit line pillar 13. The first bit line pillar 13 includes the first dielectric layer 131, the first insulating layer 132, the first contact layer 133, a first barrier layer 134, the first conductive layer 135, and the first bit line cap layer 136 that are successively stacked in the thickness direction (e.g., the oy direction).

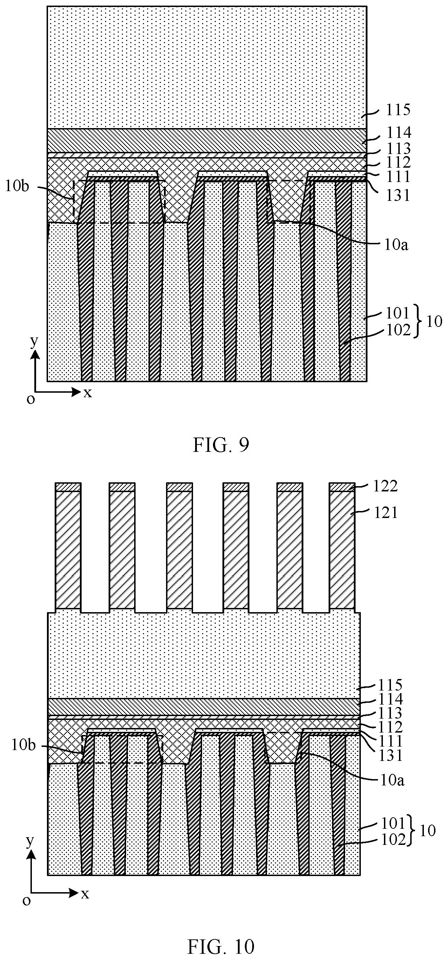

In an example, reference is made to FIG. 8 and FIG. 9. In the step of S42, the material of the insulating material layer 111 may include silicon nitride, the material of the plug material layer 112 may include polysilicon, the material of the barrier material layer 113 may be selected from tantalum, tantalum nitride, titanium, titanium nitride, and a combination thereof, the material of the conductive material layer 114 may be selected from tungsten, tantalum, molybdenum, gold, silver, and a combination thereof, and the cap material layer 115 may include silicon nitride.

In an example, reference is made to FIG. 10, FIG. 11, and FIG. 12. Forming the first conductive layer 135 and the first bit line cap layer 136 in the step of S43 includes the step as follows.

In the step of S431, the cap material layer 115 is etched in a second preset process environment, and the conductive material layer 114 is etched in a third preset process environment. A portion of the remaining conductive material layer 114 on a top surface of the first barrier layer 134 forms the first conductive layer 135, a portion of the remaining conductive material layer 114 on a top surface of the second barrier layer 142 forms a second conductive layer 143, a portion of the remaining cap material layer 115 on a top surface of the first conductive layer 135 forms the first bit line cap layer 136, and a portion of the remaining cap material layer 115 on a top surface of the second conductive layer 143 forms a second bit line cap layer 144.

In an example, reference is made to FIG. 10. The step of S431 includes the steps as follows.

In the step of S4311, a first mask layer 121 and a second mask layer 122 that are arranged at intervals are formed on the surface of the cap material layer 115. The second mask layer 122 is located on a top surface of the first mask layer 121.

In the step of S4311, a material of the first mask layer 121 may be an amorphous carbon layer (ACL), and a material of the second mask layer 122 may be silicon oxynitride. A process of forming the first mask layer 121 and the second mask layer 122 may be performed through deposition, patterned etching, or the like, and the first mask layer 121 and the second mask layer 122 are formed through etching in a fifth preset process environment. The fifth preset process environment includes a fifth process gas and a fifth preset pressure. The fifth process gas is selected from carbonyl sulfide (COS), oxygen, nitrogen, and a combination thereof, and a range of the fifth preset pressure is [4 mt, 6 mt]. Specifically, a flow rate range of carbonyl sulfide (COS) is [50 sccm, 70 sccm], a flow rate range of oxygen is [140 sccm, 160 sccm], and a flow rate range of nitrogen is [70 sccm, 90 sccm].

In the step of S4312, the cap material layer 115 is etched in the second preset process environment.

In the step of S4313, the conductive material layer 114 is etched in the third preset process environment.

In an example, in the fifth preset process environment, the fifth preset pressure may be 4 mt, 4.5 mt, 5 mt, 6 mt, or the like. A flow rate of carbonyl sulfide (COS) may be 50 sccm, 60 sccm, 65 sccm, 70 sccm, or the like. A flow rate of oxygen may be 140 sccm, 145 sccm, 150 sccm, 160 sccm, or the like. A flow rate of nitrogen may be 70 sccm, 75 sccm, 80 sccm, 90 sccm, or the like.

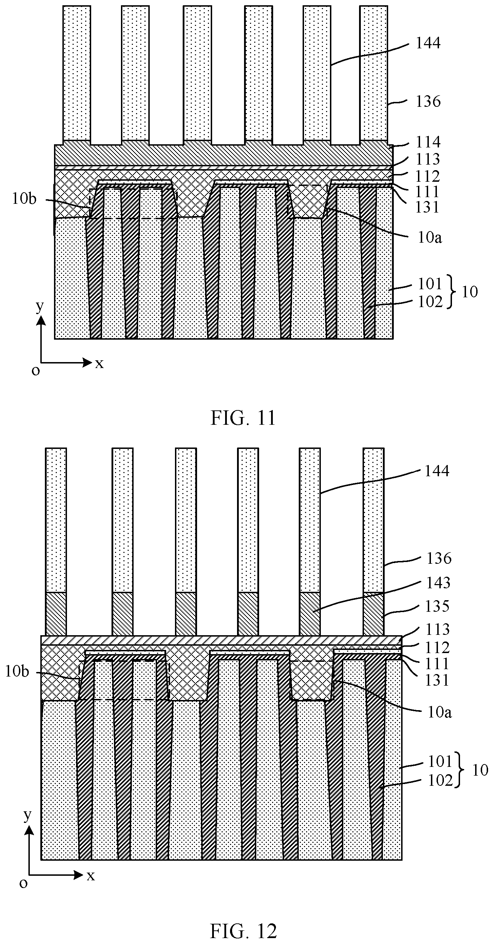

In an example, reference is made to FIG. 11. The second preset process environment includes a second process gas and a second preset pressure. The second process gas is selected from carbon tetrafluoride (CF4), trifluoromethane (CHF3), oxygen, nitrogen, an inert gas, and a combination thereof, and a range of the second preset pressure is [13 mt, 17 mt]. Specifically, a flow rate range of carbon tetrafluoride is [70 sccm, 80 sccm], a flow rate range of trifluoromethane is [220 sccm, 230 sccm], a flow rate range of oxygen is [30 sccm, 40 sccm], and a flow rate range of argon is [140 sccm, 160 sccm].

In an example, in the second preset process environment, the second preset pressure may be 13 mt, 14 mt, 15 mt, 17 mt, or the like. A flow rate of carbon tetrafluoride may be 70 sccm, 72 sccm, 75 sccm, 80 sccm, or the like. A flow rate of trifluoromethane may be 220 sccm, 222 sccm, 225 sccm, 230 sccm, or the like. A flow rate of oxygen may be 30 sccm, 32 sccm, 36 sccm, 40 sccm, or the like. A flow rate of argon may be 140 sccm, 145 sccm, 150 sccm, 160 sccm, or the like.

In an example, reference is made to FIG. 12. The third preset process environment includes a third process gas and a third preset pressure. The third process gas is selected from chlorine, nitrogen trifluoride, oxygen, nitrogen, an inert gas, and a combination thereof, and a range of the third preset pressure is [4 mt, 6 mt]. Specifically, a flow rate range of chlorine is [19 sccm, 23sccm], a flow rate range of nitrogen trifluoride is [11 sccm, 12 sccm], a flow rate range of oxygen is [20 sccm, 22 sccm], a flow rate range of argon is [18 sccm, 22 sccm], and a flow rate range of nitrogen is [110 sccm, 114 sccm].

In an example, in the third preset process environment, the third preset pressure may be 3 mt, 4 mt, 4.5 mt, 5 mt, or the like. A flow rate of chlorine may be 19 sccm, 20 sccm, 21 sccm, 23 sccm, or the like. A flow rate of nitrogen trifluoride may be 11 sccm, 11.2 sccm, 11.5 sccm, 12 sccm, or the like. A flow rate of oxygen may be 20 sccm, 21 sccm, 21.5 sccm, 22 sccm, or the like. A flow rate of argon may be 18 sccm, 19 sccm, 20 sccm, 22 sccm, or the like. A flow rate of nitrogen may be 110 sccm, 112 sccm, 114 sccm, or the like.

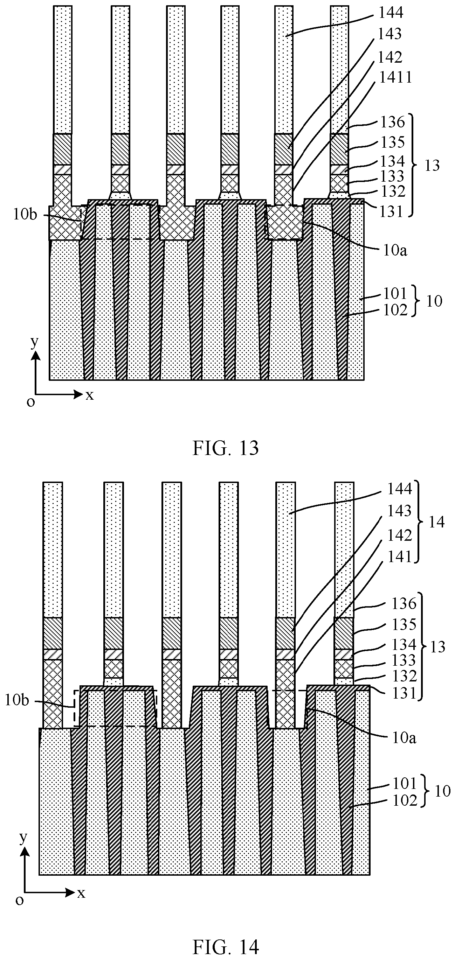

In an example, reference is made to FIG. 13. Forming the first insulating layer 132, the first contact layer 133, and the first barrier layer 134 in the step of S44 includes the step as follows.

In the step of S441, the insulating material layer 111, the plug material layer 112, and the barrier material layer 113 are etched in a first preset process environment. The remaining insulating material layer 111 forms the first insulating layer 132, a portion of the remaining plug material layer 112 on the top surface of the first insulating layer 132 forms the first contact layer 133, portions of the remaining plug material layer 112 within the groove 10a and on a top surface of the groove 10a form an intermediate plug layer 1411, a portion of the remaining barrier material layer 113 on a top surface of the first contact layer 133 forms the first barrier layer 134, and a portion of the remaining barrier material layer 113 on a top surface of the intermediate plug layer 1411 forms a second barrier layer 142.

In an example, reference is made to FIG. 13. In the step of S441, the insulating material layer 111, the plug material layer 112, and the barrier material layer 113 are etched in the first preset process environment, and sidewall morphologies of the insulating material layer 111, the plug material layer 112, and the barrier material layer 113 are set to be perpendicular to a surface of the substrate 10. Because the thicknesses of the insulating material layer 111 and the plug material layer 112 are controlled, during vertical etching, the sidewalls of the first contact layer 133 and the first insulating layer 132 can be better perpendicular to a first direction (e.g., an ox direction), and a difference between a length of the top surface of the first insulating layer 132 and a length of the bottom surface of the first insulating layer 132 in the first direction (e.g., the ox direction) is reduced, thereby reducing a parasitic capacitance while ensuring verticality of the first bit line pillar 13.

In an example, reference is still made to FIG. 13. The first preset process environment includes a first process gas and a first preset pressure. The first process gas is selected from chlorine, nitrogen trifluoride, nitrogen, an inert gas, and a combination thereof, and a range of the first preset pressure is [4 mt, 6 mt]. Specifically, a flow rate range of chlorine is [25 sccm, 35 sccm], a flow rate range of nitrogen trifluoride is [8 sccm, 10 sccm], a flow rate range of helium is [160 sccm, 180 sccm], and a flow rate range of nitrogen is [180 sccm, 200 sccm].

In an example, in the first preset process environment, the first preset pressure may be 4 mt, 5 mt, 5.5 mt, 6 mt, or the like. A flow rate of chlorine may be 25 sccm, 28 sccm, 30 sccm, 35 sccm, or the like. A flow rate of nitrogen trifluoride may be 8 sccm, 9 sccm, 9.5 sccm, 10 sccm, or the like. A flow rate of helium may be 160 sccm, 165 sccm, 170 sccm, 180 sccm, or the like. A flow rate of nitrogen may be 180 sccm, 190 sccm, 200 sccm, or the like.

In an example, reference is made to FIG. 14. After forming the first bit line pillar 13, the method further includes the step as follows.

In the step of S5, the intermediate plug layer 1411 is processed in a fourth preset process environment to form bit line plugs 141 that are arranged at intervals in the first direction (e.g., the ox direction), so as to form a second bit line pillar 14. The second bit line pillar 14 includes the bit line plug 141, the second barrier layer 142, the second conductive layer 143, and the second bit line cap layer 144 that are successively stacked in the thickness direction (e.g., the oy direction).

In an example, reference is still made to FIG. 14. The fourth preset process environment includes a fourth process gas and a fourth preset pressure. The fourth process gas is selected from hydrogen bromide (HBr), oxygen, an inert gas, and a combination thereof, and a range of the fourth preset pressure is [18 mt, 22 mt]. Specifically, a flow rate range of hydrogen bromide is [460 sccm, 500 sccm], a flow rate range of oxygen is [16 sccm, 20 sccm], and a flow rate range of helium is [2500 sccm, 3500 sccm].

In an example, in the fourth preset process environment, the fourth preset pressure may be 18 mt, 19 mt, 20 mt, 22 mt, or the like. A flow rate of hydrogen bromide may be 460 sccm, 470 sccm, 480 sccm, 500 sccm, or the like. A flow rate of oxygen may be 16 sccm, 18 sccm, 19 sccm, 20 sccm, or the like. A flow rate of helium may be 2500 sccm, 2800 sccm, 3000 sccm, 3500 sccm, or the like.

In an example, reference is made to FIG. 3 and FIG. 15 to FIG. 20. After forming the first bit line pillar 13 and the second bit line pillar 14, the method further includes the steps as follows. In the step of S6, a first bit line side barrier 15 is formed on an outer sidewall of the first bit line pillar 13, and a second bit line side barrier 16 is formed on an outer sidewall of the second bit line pillar 14. In the step of S7, a capacitive plug 21 is formed between the first bit line pillar 13 and the second bit line pillar 14 that are adjacent to each other in the first direction (e.g., the ox direction). The capacitive plug 21 is connected to the active region 101.

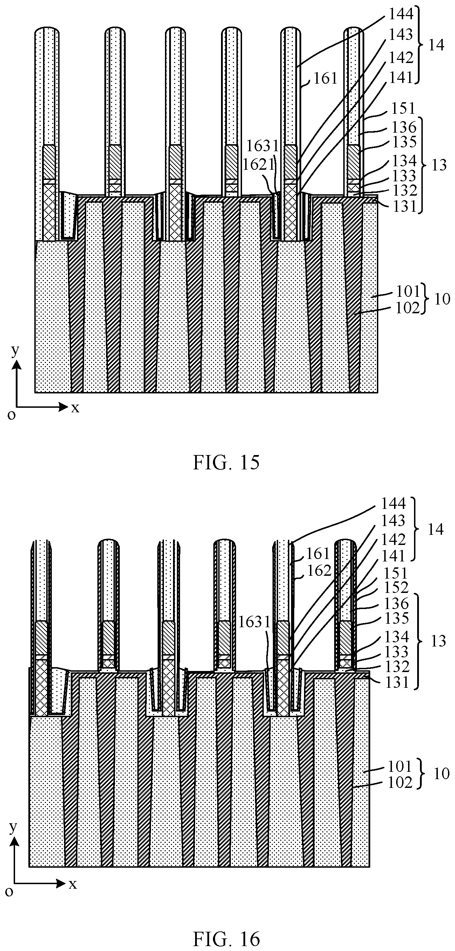

In an example, reference is made to FIG. 15. The step of S6 includes the step as follows.

In the step of S61, a first dielectric layer 151 is formed on a sidewall surface of the first bit line pillar 13, and a fourth dielectric layer 161, a fifth sub-dielectric layer 1621, and a sixth sub-dielectric layer 1631 that are successively stacked are formed on an inner wall surface of the groove 10a. The fourth dielectric layer 161 further covers a sidewall surface of the second bit line pillar 14, and the first dielectric layer 151 and the fourth dielectric layer 161 further cover a surface of the substrate 10 exposed between the first bit line pillar 13 and the second bit line pillar 14.

In the step of S61, materials of the first dielectric layer 151, the fourth dielectric layer 161, and the sixth sub-dielectric layer 1631 are the same, and may be all silicon nitride, and a material of the fifth sub-dielectric layer 1621 may be silicon oxide.

In an example, reference is made to FIG. 16. The step of S6 further includes the step as follows.

In the step of S62, a second dielectric layer 152 is formed on a surface of the first dielectric layer 151, and a fifth dielectric layer 162 is formed on a surface of the fourth dielectric layer 161. The fifth dielectric layer 162 further includes the fifth sub-dielectric layer 1621.

In the step of S62, materials of the fifth dielectric layer 162 and the fifth sub-dielectric layer 1621 are the same, and are all silicon oxide.

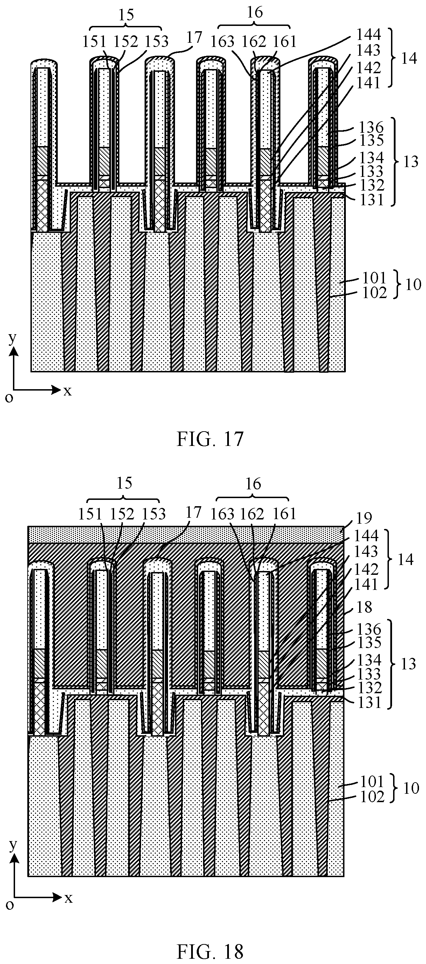

In an example, reference is made to FIG. 17. The step of S6 further includes the steps as follows.

In the step of S63, a third dielectric layer 153 is formed on a surface of the second dielectric layer 152 and a top surface of the first bit line pillar 13, and a sixth dielectric layer 163 is formed on a surface of the fifth dielectric layer 162 and a top surface of the second bit line pillar 14. The sixth dielectric layer 163 further includes the sixth sub-dielectric layer 1631.

In the step of S64, a first isolation layer 17 is formed on a surface of the third dielectric layer 153, a surface of the sixth dielectric layer 163, and the surface of the substrate 10 between the first bit line pillar 13 and the second bit line pillar 14.

In the step of S63, materials of the sixth dielectric layer 163 and the sixth sub-dielectric layer 1631 are the same, and are all silicon nitride.

In the step of S64, a material of the first isolation layer 17 may be silicon oxide.

In an example, reference is made to FIG. 18. After the step of S64, the method may further include the step as follows.

In the step of S65, a second isolation layer 18 is formed in a gap between the first bit line pillar 13 and the second bit line pillar 14. The second isolation layer 18 further covers the surfaces of the first bit line pillar 13 and the second bit line pillar 14, and a third isolation layer 19 is formed on a surface of the second isolation layer 18.

In the step of S65, materials of the second isolation layer 18 and the third isolation layer 19 may be one or more of any insulating materials.

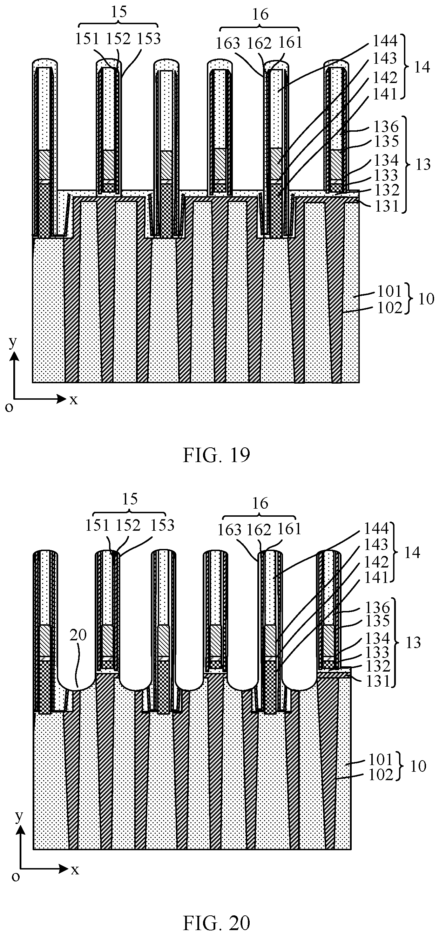

In an example, reference is made to FIG. 19 and FIG. 20. After the step of S63, the method may further include the step as follows.

In the step of S64', a capacitive plug trench 20 is formed on the surface of the substrate 10 between the first bit line pillar 13 and the second bit line pillar 14. A bottom surface of the capacitive plug trench 20 is higher than a bottom surface of the groove, and is connected to the active region 101.

In the step of S64', a process of forming the capacitive plug trench 20 may include dry etching or wet etching.

In an example, reference is made to FIG. 3. After the step of S64', the method may further include the step as follows.

In the step of S65', a capacitive plug 21 is formed at least in the capacitive plug trench 20, and a capacitor contact layer (not shown in the figure) is formed on a top surface of the capacitive plug 21.

According to the semiconductor structure and the method for fabricating same in the foregoing embodiments, verticality of the sidewall of the first insulating layer is controlled by controlling the thickness of the first insulating layer, that is, the first preset thickness. In addition, a difference between the length of the top surface of the first insulating layer in the first direction and the length of the bottom surface of the first insulating layer in the first direction is smaller. A length ratio is controlled to be the first target value, and verticality and performance of the first bit line pillar are better. In addition, better verticality of the first insulating layer can also leave more space in a sidewall direction of the first insulating layer, so that a thickness of the first bit line side barrier increases, thereby reducing a parasitic capacitance, expanding a process window, and further improving overall performance of a storage structure. According to the present disclosure, the thicknesses of the first bit line cap layer and the second bit line cap layer are further reduced, so as to alleviate a problem that a bit line pillar is prone to tilt, and improve stability of the bit line pillar.

It should be noted that the foregoing embodiments are for illustrative purposes only and are not intended to limit the present disclosure.

The embodiments in this specification are described in a progressive manner. Each embodiment focuses on a difference from other embodiments. For same or similar parts of the embodiments, mutual references can be made to the embodiments.

The technical features in the foregoing embodiments may be combined arbitrarily. For brevity of description, not all possible combinations of these technical features in the foregoing embodiments are described. However, as long as these combinations of technical features are not contradictory, they should all be considered within the scope described in this specification.

The foregoing embodiments represent only several implementations of the present disclosure, and descriptions thereof are relatively specific and detailed, but should not be construed as limitations on the patent scope of the present disclosure. It should be noted that, a person of ordinary skill in the art can further make several variations and improvements without departing from the concept of the present disclosure, all of which shall fall within the protection scope of the present disclosure.

## Claims

1. A semiconductor structure, comprising:
a substrate (10);
a first bit line pillar (13), the first bit line pillar (13) being located on the substrate (10), and comprising a first dielectric layer (131), a first insulating layer (132), and a first contact layer (133) that are successively stacked in a thickness direction of the substrate (10), and the first insulating layer (132) being adjacent to the substrate (10);
the first insulating layer (132) having a first preset thickness, and the first preset thickness being associated with a thickness sum of the first dielectric layer (131), the first insulating layer (132), and the first contact layer (133); a ratio of a length of a top surface of the first insulating layer (132) in a first direction (ox) to a length of a bottom surface of the first insulating layer (132) in the first direction (ox) being a first target value; and the first direction (ox), the top surface and the bottom surface of the first insulating layer (132) all being perpendicular to the thickness direction (oy).

2. The semiconductor structure according to claim 1, wherein the first preset thickness is negatively correlated with both a thickness of the first dielectric layer (131) and a thickness of the first contact layer (133); and a range of the first preset thickness is [1/6 T, 1/4 T], wherein T is the thickness sum of the first dielectric layer (131), the first insulating layer (132), and the first contact layer (133).

3. The semiconductor structure according to claim 2, comprising at least one of the following features:
the range of the first preset thickness is [3 nm, 10 nm]; and
a range of the first target value is [0.8, 1].

4. The semiconductor structure according to any one of claims 1 to 3, further comprising:
a first bit line side barrier (15), the first bit line side barrier (15) being located on an outer sidewall of the first bit line pillar (13), and a length of the first bit line side barrier (15) in the first direction (ox) being associated with a length of a bottom surface of the first insulating layer (132) in the first direction (ox).

5. The semiconductor structure according to claim 4, wherein the length of the first bit line side barrier (15) in the first direction (ox) is negatively correlated with the length of the bottom surface of the first insulating layer (132) in the first direction (ox).

6. The semiconductor structure according to any one of claims 1 to 3, wherein the substrate (10) comprises an active region (101) and an isolation structure (102) that are alternately arranged in the first direction (ox), the substrate (10) comprises a groove (10a) and a convex part (10b) that are alternately arranged in the first direction (ox), and the first bit line pillar (13) is located on a top surface of the convex part (10b) and is connected to the isolation structure (102) under the first bit line pillar (13); and
the semiconductor structure further comprises:
a second bit line pillar (14), the second bit line pillar (14) being partially located within the groove (10a), and being connected to an active region (101) exposed by the groove (10a).

7. The semiconductor structure according to any one of claims 1 to 3, wherein the first bit line pillar (13) further comprises a first barrier layer (134), a first conductive layer (135), and a first bit line cap layer (136) that are successively stacked in the thickness direction of the substrate, the first contact layer (133) is adjacent to the first barrier layer (134), and a thickness range of the first bit line cap layer (136) is [10 nm, 30 nm].

8. The semiconductor structure according to claim 6, wherein the second bit line pillar (14) comprises a bit line plug (141), a second barrier layer (142), a second conductive layer (143), and a second bit line cap layer (144) that are successively stacked in the thickness direction, the bit line plug (141) is connected to the active region (101) exposed by the groove (10a), and a thickness range of the second bit line cap layer (144) is [10 nm, 30 nm].

9. A method for fabricating a semiconductor structure, comprising:
providing a substrate (10);
forming a first bit line pillar (13) on the substrate, the first bit line pillar (13) comprising a first dielectric layer (131), a first insulating layer (132), and a first contact layer (133) that are successively stacked in a thickness direction of the substrate, and the first insulating layer (132) being adjacent to the substrate (10);
the first insulating layer (132) having a first preset thickness, and the first preset thickness being associated with a thickness sum of the first dielectric layer (131), the first insulating layer (132), and the first contact layer (133); a ratio of a length of a top surface of the first insulating layer (132) in a first direction (ox) to a length of a bottom surface of the first insulating layer (132) in the first direction (ox) having a first target value; and the first direction (ox), the top surface and the bottom surface of the first insulating layer (132) all being perpendicular to the thickness direction.

10. The method for fabricating a semiconductor structure according to claim 9, wherein the substrate (10) comprises an active region (101) and an isolation structure (102) that are alternately arranged in the first direction (ox), and the substrate (10) comprises a groove (10a) and a convex part (10b) that are alternately arranged in the first direction (ox); the first dielectric layer (131) is located on the convex part (10b), and the first bit line pillar (13) is located on a top surface of the convex part (10b) and is connected to the isolation structure (102) under the first bit line pillar (13); and forming the first bit line pillar (13) comprises:
successively forming, on the substrate (10), an insulating material layer (111), a plug material layer (112), a barrier material layer (113), a conductive material layer (114), and a cap material layer (115) that are stacked in the thickness direction, the insulating material layer (111) being located on the first dielectric layer (131) on the convex part (10b), and the plug material layer (112) at least filling the groove (10a);
etching the conductive material layer (114) and the cap material layer (115) to form a first conductive layer (135) and a first bit line cap layer (136) that are successively stacked in the thickness direction; and
etching the insulating material layer (111), the plug material layer (112), and the barrier material layer (113) to form the first bit line pillar (13), the first bit line pillar (13) comprising the first dielectric layer (131), the first insulating layer (132), the first contact layer (133), a first barrier layer (134), the first conductive layer (135), and the first bit line cap layer (136) that are successively stacked in the thickness direction.

11. The method for fabricating a semiconductor structure according to claim 10, wherein forming the first insulating layer (132), the first contact layer (133), and the first barrier layer (134) comprises:
etching the insulating material layer (111), the plug material layer (112), and the barrier material layer (113) in a first preset process environment, the remaining insulating material layer (111) forming the first insulating layer (132), a portion of the remaining plug material layer (112) on the top surface of the first insulating layer (132) forming the first contact layer (133), portions of the remaining plug material layer (112) within the groove (10a) and on a top surface of the groove (10a) forming an intermediate plug layer (1411), a portion of the remaining barrier material layer (113) on a top surface of the first contact layer (133) forming the first barrier layer (134), and a portion of the remaining barrier material layer (113) on a top surface of the intermediate plug layer (1411) forming a second barrier layer (142).

12. The method for fabricating a semiconductor structure according to claim 11, wherein the first preset process environment comprises a first process gas and a first preset pressure; the first process gas is selected from chlorine, nitrogen trifluoride, nitrogen, an inert gas, and a combination thereof; and a range of the first preset pressure is [4 mt, 6 mt].

13. The method for fabricating a semiconductor structure according to claim 11, wherein forming the first conductive layer (135) and the first bit line cap layer (136) comprises:
etching the cap material layer (115) in a second preset process environment, and etching the conductive material layer (114) in a third preset process environment, a portion of the remaining conductive material layer (114) on a top surface of the first barrier layer (134) forming the first conductive layer (135), a portion of the remaining conductive material layer (114) on a top surface of the second barrier layer (142) forming a second conductive layer (143), a portion of the remaining cap material layer (115) on a top surface of the first conductive layer (135) forming the first bit line cap layer (136), and a portion of the remaining cap material layer (115) on a top surface of the second conductive layer (143) forming a second bit line cap layer (144).

14. The method for fabricating a semiconductor structure according to claim 13, after forming the first bit line pillar (13), further comprising:
processing the intermediate plug layer (1411) in a fourth preset process environment to form bit line plugs (141) that are arranged at intervals in the first direction (ox), so as to form a second bit line pillar (14), the second bit line pillar (14) comprising the bit line plug (141), the second barrier layer (142), the second conductive layer (143), and the second bit line cap layer (144) that are successively stacked in the thickness direction.

15. The method for fabricating a semiconductor structure according to claim 14, comprising at least one of the following features:
the second preset process environment comprises a second process gas and a second preset pressure; the second process gas is selected from carbon tetrafluoride, trifluoromethane, oxygen, nitrogen, an inert gas, and a combination thereof; and a range of the second preset pressure is [13 mt, 17 mt];
the third preset process environment comprises a third process gas and a third preset pressure; the third process gas is selected from chlorine, nitrogen trifluoride, oxygen, nitrogen, an inert gas, and a combination thereof; and a range of the third preset pressure is [4 mt, 6 mt]; and
the fourth preset process environment comprises a fourth process gas and a fourth preset pressure; the fourth process gas is selected from hydrogen bromide, oxygen, an inert gas, and a combination thereof; and a range of the fourth preset pressure is [18 mt, 22 mt].
